# EUROPEAN PATENT APPLICATION

(11) **EP 1 605 525 A2**
(43) Date of publication of application: **14.12.2005**
(21) Application number: 05012018.7
(22) Date of filing: 03.06.2005
(51) Int. Cl.: H01L 33/00

(54) **High power LED package**

(30) Priority: 10.06.2004 KR 2004042723
(71) Applicant: LG ELECTRONICS INC., Seoul 150-721 (KR)
(72) Inventor: Kim, Geun-Ho, Gangnam-gu Seoul, 135-960 (KR); Park, Chil-Keun, Gangdong-gu Seoul 134-772 (KR); Song, Ki-Chang, Uiwang-city Gyeonggi-do, 437-768 (KR)
(74) Representative: Zech, Stefan Markus

(57) **Abstract**

Disclosed is a high power LED package, including an LED; a silicon submount to which the LED is flip chip bonded; a reflective film formed on the silicon submount and electrically connected to the LED to increase light emitting efficiency of the LED; electrical wires connected to the reflective film to connect the LED to an external circuit; an insulating body formed below the silicon submount; a heat sink formed below the insulating body; an insulating substrate formed on the heat sink; and metal lines formed on the insulating substrate and connected to the electrical wires. In the LED package, since the silicon submount having the LED flip chip bonded thereto is directly attached to the heat sink, heat generated upon operation of the LED can be effectively radiated. Also, the LED package has a simple structure, thus having drastically decreased manufacturing costs. The high power LED can be applied to backlight units of LCDs or general illumination fixtures, and as well, to backlight units of conventional PCS phones or LED packages for key pads, therefore increasing the light properties of the LED. In particular, the LED package has an array of two or more submounts each having an LED flip chip bonded thereto, and thus, it can be applied to a module of a backlight unit for LCDs, thus having remarkably reduced manufacturing costs.

## Description

### BACKGROUND OF THE INVENTION

### 1. Field of the Invention

The present invention relates, generally, to a high power LED package, and, more particularly, to a package structure that efficiently radiates heat generated upon operation of the LED.

### 2. Description of the Related Art

An LED (Light Emitting Diode), which is advantageous because it manifests energy saving effects superior to conventional light sources and may be semi-permanently used, is receiving attention as a next-generation light source in an era of light semiconductors leading compound semiconductors into the 21st century. Recently, because luminance problems of LEDs have been drastically improved, the LED is variously applied in all industrial fields, including backlight units, automobiles, electric signs, traffic signal lamps, illumination fixtures, etc.

In particular, an LED having a small size and high luminance for use in backlight units has been substituted for a CCFL lamp serving as a light source of conventional backlight units, and thus, it is expected that a production amount of LED increases in proportion to an increase in production amount of mobile apparatuses.

Further, since the high power LED radiates large quantities of heat as current applied thereto is increased, the high power LED must efficiently radiate large quantities of heat generated upon operation thereof, to achieve high reliability.

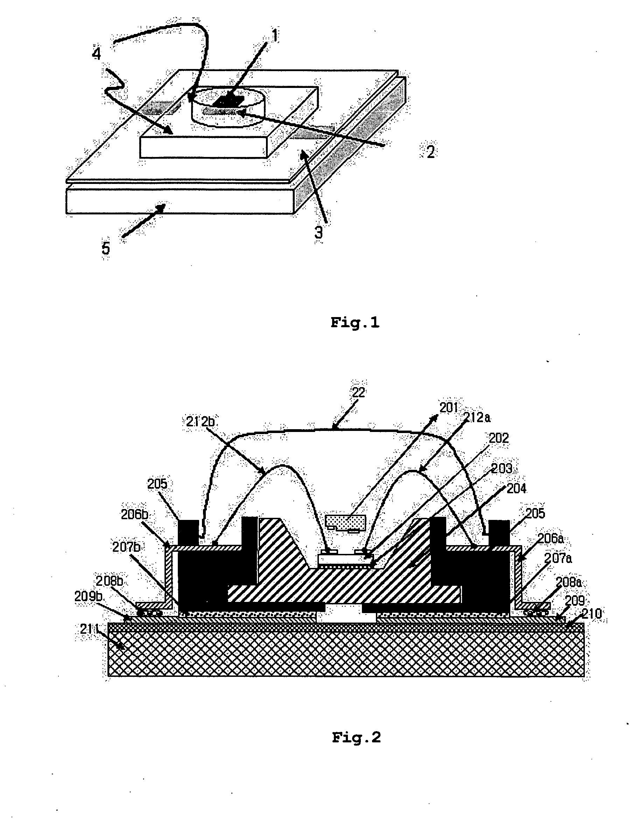

FIG. 1 is a perspective view showing an LED package for light, presently commercially available from an ' L' company.

As seen in FIG. 1, the LED package for light includes an LED 1, a silicon submount 2, an aluminum slug 4, a printed circuit board (PCB) 3 having a metal line, and an aluminum heat sink 5.

For detailed description, a sectional view of the above LED package is shown in FIG. 2.

In the LED package shown in FIG. 2, an LED 201 is flip chip bonded to a flat silicon submount 202 including a metal line (not shown) for electrical connection between the LED 201 and the submount 202 and a solder (not shown) and a solder dam (not shown) for flip chip bonding with the LED 201. In addition, the submount 202 having the LED 201 flip chip bonded thereto is attached to an aluminum slug 204 having a mirror surface using an adhesive 203.

Further, the LED package includes leads 206a and 206b each held by a plastic body 205, which are electrically connected to electrode metals of the silicon submount 202 through inductive wires 212a and 212b, respectively. As such, the leads 206a and 206b are connected to metal lines 209a and 209b of a PCB 210 via welded parts 208a and 208b, in which the PCB 210 is attached to the plastic body 205 via adhesives 207a and 207b. Also, an aluminum heat sink 211 to radiate heat is included.

In the above LED package, heat generated upon operation of the LED is not directly transferred to the aluminum heat sink 211 manifesting excellent heat radiation ability, but is transferred thereto through the plastic body 205 and the PCB 210, both of which have a low heat transfer rate, thus reducing heat radiation ability, resulting in deteriorated light properties of the LED .

Particularly, although larger quantities of heat are generated upon operating the high power LED applied to backlight units for LCDs and general illumination fixtures, the LED exhibits insignificant heat radiation ability, therefore further deteriorating the light properties of the LED.

### SUMMARY OF THE INVENTION

Accordingly, the present invention has been made keeping in mind the above problems occurring in the related art, and an object of the present invention is to provide a high power LED package for use in backlight units of LCDs and general illumination fixtures, in which a silicon submount having an LED bonded thereto is directly attached to a heat sink to form an LED package, thus increasing heat radiation properties of the LED.

Another object of the present invention is to provide a high power LED package, which can be applied to backlight units of mobile apparatuses, such as PCS phones, or LED packages for key pads.

A further object of the present invention is to provide a high power LED package, which comprises the array of two or more submounts each having an LED flip chip bonded thereto.

According to an aspect of the present invention, there is provided a high power LED package, which comprises an LED, a silicon submount to which the LED is flip chip bonded, a reflective film formed on the silicon submount and electrically connected to the LED to increase the light emitting efficiency of the LED, electrical wires connected to the reflective film to connect the LED to an external circuit, an insulating body formed below the silicon submount, a heat sink provided below the insulating body, an insulating substrate formed on the heat sink, and metal lines formed on the insulating substrate and connected to the electrical wires.

According to another aspect of the present invention, there is provided a high power LED package, which comprises an LED, a silicon submount to which the LED is flip chip bonded, a reflective film formed on the silicon submount and electrically connected to the LED to increase the light emitting efficiency of the LED, electrical wires connected to the reflective film to connect the LED to an external circuit, a heat sink formed of a nonconductor and provided below the silicon submount, and metal lines formed on the heat sink and connected to the electrical wires.

According to a further aspect of the present invention, there is provided a high power LED package, which comprises at least one element unit including an LED, a silicon submount to which the LED is flip chip bonded, a reflective film formed on the silicon submount and electrically connected to the LED to increase the light emitting efficiency of the LED, electrical wires connected to the reflective film to connect the LED to an external circuit and an insulating body formed below the silicon submount, a heat sink provided below the insulating body, an insulating substrate formed on the heat sink, and metal lines formed on the insulating substrate, wherein the electrical wires of the at least one element unit are connected to the metal lines on the insulating substrate formed on the heat sink.

According to still another aspect of the present invention, there is provided a high power LED package, which comprises at least one element unit including an LED, a silicon submount to which the LED is flip chip bonded, a reflective film formed on the silicon submount and electrically connected to the LED to increase the light emitting efficiency of the LED and electrical wires connected to the reflective film to connect the LED to an external circuit, a heat sink formed of a nonconductor and provided below the submount, and metal lines formed on the heat sink, wherein the electrical wires of the at least one element unit are connected to the metal lines formed on the heat sink.

The LED package may further comprise a lens to cover the LED to increase the light emitting efficiency of the LED, and the heat sink is preferably formed of a conductor or a nonconductor.

Each of the metal lines may include a P-metal line or an N-metal line, and the silicon submount preferably has a groove in an upper surface thereof to receive the LED for flip chip bonding therein.

The groove of the submount may be formed by wet etching using a potassium hydroxide solution, and the submount may further include a Zener diode to prevent electrostatic damage to the LED. Also, the heat sink may be formed of a material having excellent heat conductivity and a heat expansion coefficient similar to that of the submount, and is preferably selected from the group consisting of silicon carbide (SiC), aluminum nitride (AlN), aluminum oxide (AlOx), aluminum (Al), copper (Cu), and mixtures thereof.

The LED and the submount may be directly attached to the upper surface of the heat sink using an adhesive. As such, the adhesive is selected from the group consisting of an aluminum paste, a silver paste, and mixtures thereof.

### BRIEF DESCRIPTION OF THE DRAWINGS

The above and other objects, features and advantages of the present invention will be more clearly understood from the following detailed description taken in conjunction with the accompanying drawings, in which:
FIG. 1 is a perspective view showing an LED package for conventional light;
FIG. 2 is a sectional view showing the LED package for conventional light;
FIG. 3 is a sectional view showing an LED package, according to a first embodiment of the present invention;
FIG. 4 is a sectional view showing an LED package, according to a second embodiment of the present invention; and
FIG. 5 is a perspective view showing the LED package in an array configuration, according to the present invention.

### DESCRIPTION OF THE PREFERRED EMBODIMENTS

Hereinafter, preferred embodiments of the present invention are described, with reference to the appended drawings. Reference is now made to the drawings, in which the same reference numerals are used throughout the different drawings to designate the same or similar components. Also, a detailed description of known functions and structures which are considered to be unnecessary for essential points of the present invention is omitted.

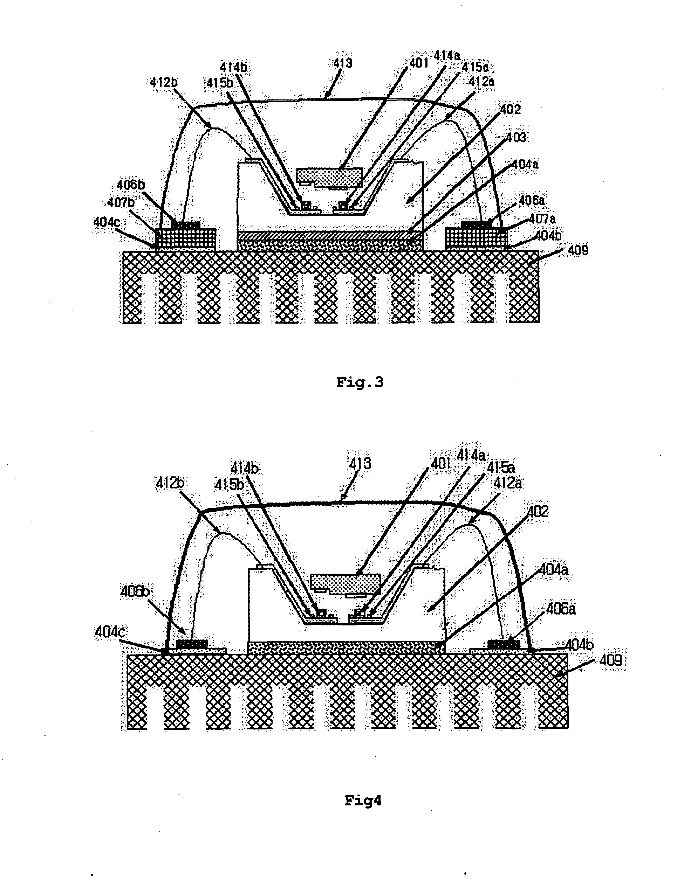

FIG. 3 is a sectional view showing the high power LED package, according to a first embodiment of the present invention.

According to the first embodiment, the high power LED package includes an LED 401, a silicon submount 402, an insulating layer 403, an adhesive 404a, metal lines 406a and 406b, insulating substrates 407a and 407b, a heat sink 409, electrical wires 412a and 412b, a lens 413, solders 414a and 414b, and solder dams 415a and 415b.

In the high power LED package, the silicon submount 402 having the LED 401 flip chip bonded thereto is directly attached to the upper surface of the heat sink 409 using the adhesive 404a. As such, the adhesive 404a includes a material having excellent heat conductivity and a heat expansion coefficient similar to that of the submount 402, and is exemplified by an aluminum paste, and a silver paste. Further, the heat sink 409 may be formed of a conductor or a nonconductor.

Referring to FIG. 3, the silicon submount 402 has a groove to receive the LED 401 therein. The groove of the submount 402 is formed by subjecting a silicon wafer, which is mainly used to manufacture a submount, to wet etching using a potassium hydroxide solution. The process of forming the groove of the submount 402 is not limited to the above procedure, and any process which is known to those to be capable of forming the groove may be employed.

In the LED package are provided the electrical wires 412a and 412b to electrically connect the LED 401 to an external circuit, a reflective film (not shown) to increase the light emitting efficiency of the LED 401, the solders 414a and 414b and the solder dams 415a and 415b to subject the LED 401 to flip chip bonding, and the insulating layer 403 to provide insulation from the heat sink 409. Thus, the LED package in which the LED 401 is flip chip bonded to the silicon submount 402 has a function equal to a conventional LED package in which an LED is flip chip bonded to a flat silicon submount without a groove and then attached to an aluminum slug having a mirror surface.

When the LED 401 having a P-metal and an N-metal formed thereon is flip chip bonded to the silicon submount 402, the surface of the LED 401 on which the P-metal is formed is bonded to the silicon submount 402, whereby the P-metal (not shown) of the LED 401 may be formed into a thick metal having high reflectivity. Consequently, low V_{f} properties are realized with decreasing resistance at high current, and as well, excellent heat radiation properties are manifested due to the short heat radiation path.

In addition, the submount 402 has high heat conductivity of silicon and improved reliability at high temperatures due to the use of a metal solder such as gold-tin (AuSn) deposited using an E-beam deposition process. Also, the submount 402 further includes a Zener diode mounted thereto, so that the LED 401 may be prevented from fatal damage due to electrostatic discharge.

The heat sink 409 functions to sufficiently radiate heat generated upon operation of the LED 401 by enlarging its surface area with the use of a material, such as SiC, AlN, AlOx, Al, Cu, etc., having excellent heat conductivity and a heat expansion coefficient similar to that of the submount 402.

In order to externally electrically connect the LED 401, metal line substrates, such as PCBs, including the insulating substrates 407a and 407b and the conductive metal lines 406a and 406b, that is, the P-metal line 406a and the N-metal line 406b, formed thereon, are attached onto the heat sink 409 in such a way that the P-metal line 406a and the N-metal line 406b are not connected to each other and do not overlap each other to prevent electrical short from occurring. As such, adhesives 404b and 404c, which are the same as the adhesive 404a used for attachment of the silicon submount 402, are used in the attachment of the metal line substrates to the heat sink 409. The above metal line substrates may be simultaneously attached to the upper surface of the heat sink 409 when the submount 402 is bonded thereto.

The silicon submount 402 to which the LED 401 is flip chip bonded and electrically connected is connected to the metal lines 406a and 406b using an inductive wire such as Au or Al. In addition, the lens 413 is provided on the insulating substrates 407a and 407b of the metal line substrates or on the heat sink 409, to increase the light emitting efficiency of the LED 401.

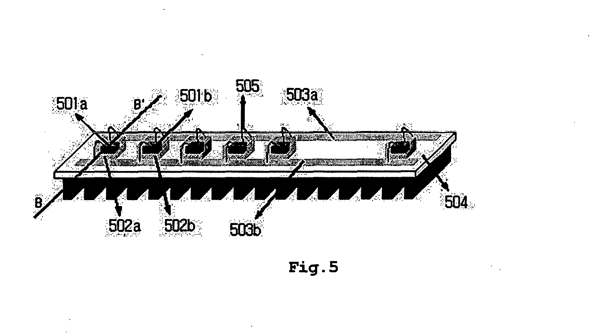

FIG. 4 is a sectional view showing the high power LED package, according to a second embodiment of the present invention. In the above LED package, a silicon submount 402 having an LED 401 flip chip bonded thereto is directly attached to the upper surface of a heat sink 409 composed of a nonconductor including an insulating film formed of AlN, AlOx, etc. Also, the LED 401 is electrically connected to the exterior via a predetermined metal line, which includes conductive metal lines 406a and 406b provided on the insulating substrates 407a and 407b of the PCB as in the LED package shown in FIG. 3, or conductive metal lines 406a and 406b directly attached to the upper surface of the heat sink 409 without insulating substrates 407a and 407b.

Adhesives 404a, 404b and 404c, wires 412a and 412b, and a lens 413 remain the same as in the first embodiment of the present invention shown in FIG. 3.

Turning now to FIG. 5, a perspective view showing the LED package in an array configuration, according to the present invention, is shown.

As is apparent from FIG. 5, silicon submounts 502a and 502b having LEDs 501a and 501b, respectively, flip chip bonded thereto are directly attached to a heat sink 504. Thereby, heat generated upon operation of the LED is directly radiated via the heat sink 504 while not passing through the PCB having a low heat transfer rate, thus increasing heat radiation properties.

In FIG. 5, when the two or more submounts 502a and 502b having LEDs 501a and 501b, respectively, flip chip bonded thereto are arranged to form an LED package, the submounts 502a and 502b are directly attached to the heat sink 504 and only one P-metal line 503a and only one N-metal line 503b are used so as not to be connected to each other and not to overlap each other.

The silicon submounts 502a and 502b to which the LEDs 501a and 501b are flip chip bonded and electrically connected, respectively, are connected to the P-metal line 503a and the N-metal line 503b, which are provided on the heat sink 504, using an inductive wire 505. Thus, when external current is applied to the P-metal line 503a and the N-metal line 503b, it flows in the LEDs 501a and 501b of all of the submounts through the P-metal line 503a and the N-metal line 503b electrically connected thereto. An adhesive (not shown) for use in the connection between the submounts 502a and 502b and the metal lines 503a and 503b, the wire 505, and a lens (not shown) remain the same as in the first embodiment of the present invention shown in FIG. 3.

In addition, using the LED package shown in FIG. 4, an LED package in another array configuration including a heat sink 504 and metal lines 503a and 503b may be formed. The sectional view of FIG. 3 or 4 is a sectional view taken along the line B-B' of FIG. 5.

As described hereinbefore, the present invention provides a high power LED package. In the present invention, since the silicon submount having an LED bonded thereto is directly attached to a heat sink, heat generated upon operation of the LED can be effectively radiated, and the LED package structure is simplified, thus drastically decreasing the manufacturing costs.

The high power LED package of the present invention can be applied to backlight units of LCDs or general illumination fixtures, and as well, to backlight units of conventional PCS phones or LED packages for key pads, therefore increasing the light properties of the LED.

In particular, the LED package obtained by arranging two or more submounts each having an LED flip chip bonded thereto may be applied to a module of a backlight unit for LCDs, thus remarkably reducing the manufacturing costs.

Although the preferred embodiments of the present invention have been disclosed for illustrative purposes, those skilled in the art will appreciate that various modifications, additions and substitutions are possible, without departing from the scope and spirit of the invention as disclosed in the accompanying claims.

## Claims

1. A high power LED package, comprising:
an LED;
a silicon submount to which the LED is flip chip bonded;
a reflective film formed on the silicon submount and electrically connected to the LED to increase light emitting efficiency of the LED;
electrical wires connected to the reflective film to connect the LED to an external circuit;
an insulating body formed below the silicon submount;
a heat sink provided below the insulating body;
an insulating substrate formed on the heat sink; and
metal lines formed on the insulating substrate and connected to the electrical wires.

2. A high power LED package, comprising:
an LED;
a silicon submount to which the LED is flip chip bonded;
a reflective film formed on the silicon submount and electrically connected to the LED to increase light emitting efficiency of the LED;
electrical wires connected to the reflective film to connect the LED to an external circuit;
a heat sink formed of a nonconductor and provided below the silicon submount; and
metal lines formed on the heat sink and connected to the electrical wires.

3. A high power LED package, comprising:
at least one element unit, which includes:
an LED,
a silicon submount to which the LED is flip chip bonded,
a reflective film formed on the silicon submount and electrically connected to the LED to increase light emitting efficiency of the LED,
electrical wires connected to the reflective film to connect the LED to an external circuit, and
an insulating body formed below the silicon submount;
a heat sink provided below the insulating body;
an insulating substrate formed on the heat sink; and
metal lines formed on the insulating substrate,
wherein the electrical wires of the at least one element unit are connected to the metal lines on the insulating substrate formed on the heat sink.

4. A high power LED package, comprising:
at least one element unit, which includes:
an LED,
a silicon submount to which the LED is flip chip bonded,
a reflective film formed on the silicon submount and electrically connected to the LED to increase light emitting efficiency of the LED, and
electrical wires connected to the reflective film to connect the LED to an external circuit;
a heat sink formed of a nonconductor and provided below the silicon submount; and
metal lines formed on the heat sink,
wherein the electrical wires of the at least one element unit are connected to the metal lines formed on the heat sink.

5. The package as set forth in any one of claims 1 to 4, further comprising a lens to cover the LED to increase the light emitting efficiency of the LED.

6. The package as set forth in any one of claims 1 to 4, wherein each of the metal lines includes a P-metal line or an N-metal line.

7. The package as set forth in any one of claims 1 to 4, wherein the silicon submount has a groove in an upper surface thereof to receive the LED for flip chip bonding therein.

8. The package as set forth in claim 7, wherein the groove of the silicon submount is formed by wet etching using a potassium hydroxide solution.

9. The package as set forth in any one of claims 1 to 4, wherein the silicon submount further includes a Zener diode to prevent electrostatic damage to the LED.

10. The package as set forth in any one of claims 1 to 4, wherein the heat sink is formed of a material having excellent heat conductivity and a heat expansion coefficient similar to that of the silicon submount, and is selected from the group consisting of silicon carbide (SiC), aluminum nitride (AlN), aluminum oxide (AlOx), aluminum (Al), copper (Cu), and mixtures thereof.

11. The package as set forth in any one of claims 1 to 4, wherein the LED and the silicon submount are directly attached to the heat sink using an adhesive.

12. The package as set forth in claim 11, wherein the adhesive is selected from the group consisting of an aluminum paste, a silver paste, and mixtures thereof.
